# NEW EUROPEAN PATENT SPECIFICATION

(11) **EP 0 835 336 B2**
(45) Date of publication and mention of the opposition decision: **16.09.2009**
(45) Mention of the grant of the patent: 25.09.2002
(21) Application number: 96922326.2
(22) Date of filing: 24.06.1996
(51) Int. Cl.: C30B 29/36, C30B 29/38, C30B 23/02, C30B 25/02

(54) **A DEVICE AND A METHOD FOR EPITAXIALLY GROWING OBJECTS BY CVD**
VERFAHREN UND VORRICHTUNG ZUM EPITAKTISCHEN WACHSTUM MITTELS CVD
DISPOSITIF ET PROCEDE DE CROISSANCE EPITAXIALE D'OBJETS A L'AIDE D'UN DEPOT CHIMIQUE EN PHASE VAPEUR

(30) Priority: 26.06.1995 SE 9502288
(43) Date of publication of application: 15.04.1998
(73) Proprietor: Norstel AB, 580 15 Linköping (SE)
(72) Inventor: KORDINA, Olle, S-590 54 Sturefors (SE); HALLIN, Christer, S-583 31 Linköping (SE); JANZEN, Erik, S-590 30 Borensberg (SE)
(74) Representative: Bokinge, Ole
(86) International application number: PCT/SE1996/000822
(87) International publication number: WO 1997/001658

(56) References cited:
- EP-A1- 0 554 047
- EP-A1- 0 599 468
- US-A- 3 382 113
- US-A- 4 866 005
- US-A- 5 037 502
- J. ELECTROCHEM. SOC., Volume 137, No. 11, November 1990, D.H. KUO et al., "The Effect of CH4 on CVD beta-SiC Growth", pages 3688-3692. XP000161445
- APPL. PHYS. LETT., Volume 66, No. 11, March 1995, O. KORDINA et al., "High Quality 4H-SiC Epitaxial Layers Grown by Chemical Vapor Deposition", pages 1373-1375. XP000503597
- O. KORDINA: ' "Growth and characterisation of silicon carbide power device material", pages 1 - 140', vol. 352, 01 December 1994, LINKÖPING UNIVERSITYSWEDEN, ISBN 91-7871-427-3, ISSN 0345-7524
- O.KORDINA ET AL.: '"CVD-growth of low-doped 6H SiC epitaxial films", pages 405-410', vol. 339, 1994, MATERIALS RESEARCH SOCIETY, SYMP. PROC., SE
- E. JANZEN ET AL.,: '"SiC- A semiconductor for high-power, high-temperature and high-frequency devices"; pages 283 - 290', vol. T54, June 1994, PHYSICA SCRIPTA, LINKÖPING UNI. SWEDEN

## Description

### TECHNICAL FIELD OF THE INVENTION AND PRIOR ART

The present invention relates to a device for epitaxially growing layers of SiC by Chemical Vapour Deposition on a substrate comprising a susceptor having a circumferential wall surrounding a room for receiving the substrate and means for heating said circumferential susceptor walls and thereby the substrate and a gas mixture fed to the substrate for the growth by feeding means as well as a method for epitaxially growing objects by Chemical Vapour Deposition on a substrate according to the preamble of the first appended independent method claim.

Accordingly, the invention is applicable to the growth of SiC and the problem of growing objects of a high crystalline quality and at a reasonable grow rate from the commercial point of view.

SiC single crystals are in particular grown for being used in different types of semiconductor devices, such as for examples different types of diodes, transistors and thyristors, which are intended for applications in which it is possible to benefit from the superior properties of SiC in comparison with especially Si, namely the capability of SiC to function well under extreme conditions. The large band gap between the valence band and the conduction band of SiC makes devices fabricated from said material able to operate at high temperatures, namely up to 1000 K.

However, high temperatures are needed for obtaining a good ordered growth thereof. The epitaxial growth of silicon carbide by Chemical Vapour Disposition is therefor carried out in a temperature regime of 1400-1700°C. These high temperatures are needed both to obtain decomposition by cracking of the Si- and C-containing precursor gases of said gas mixture and to ensure that the atoms are deposited on the substrate surface in an ordered manner. However, high temperatures also mean problems with impurities coming out of different types of material, so that the temperature could until now not be raised above said temperature interval, which results in such a low grow rate (some µm per hour) that it is out of the question to grow boules for forming i.a. substrates by using CVD, so that this method is only used for growing objects in the form of layers. However, it is not possible to even grow layers of SiC by CVD through the devices already known at such a high grow rate that a commercial production thereof will be really interesting. A raise of the temperature has not been tried, since that would have resulted in a rapid degradation of the walls of the susceptor due to an increased etching of hot spots thereof leading to an unacceptable incorporation of impurities therefrom into the layers grown. It is also assumed that crystalline imperfections reduces the minority carrier lifetime. A high crystalline perfection may be obtained at high temperatures or at low grow rates. The minority carrier lifetime governs the forward conduction losses and switching losses of a power device. The minority carrier lifetime is also reduced by the introduction of unwanted compensating acceptors in the N-type layer grown, so that a minority carrier lifetime acceptable for high-power bipolar devices could not be obtained until now. It is therefore important to produce layers of a high crystalline perfection at high grow rates without the introduction of compensating acceptors. Common impurities as nitrogen and oxygen may also be incorporated at lower concentrations at higher growth rates which also may influence the minority carrier lifetime positively.

As already mentioned, it is due to said low grow rates impossible to grow boules, which require grow rates in the order of millimetres per hour, by CVD, so that the seeded sublimation technique is presently used for growing boules, which may then be sliced to substrates. However, the crystalline quality of the boules grown by this technique is low in comparison with that of the SiC layers epitaxially grown by CVD. The substrates produced in this way are perforated by small holes called micropipes or pinholes, which limit the device area considerably which consequently make high-power devices of SiC not commercially interesting yet. In the seeded sublimation technique the source is a SiC powder that sublimes, whereupon the gas species are transported by a temperature gradient to the seed crystal where the growth occurs. The conditions in the gas phase are governed by thermodynamics only, which makes it difficult to keep the C/Si ratio constant due to Si vapour leakage out of the system. Furthermore, the purity of the gases used for Chemical Vapour Deposition are several orders of magnitude higher than that of the source material used for seeded sublimation growth.

### SUMMARY OF THE INVENTION

The object of the present invention is to advise a solution to the problems discussed above by providing a device and a method making it possible to epitaxially grow layers/objects by Chemical Vapour Deposition at a high grow rate while still obtaining a high crystalline quality of the object grown.

This object is obtained by providing a device and a mehtod according to the appended independent claims.

Accordingly, the present invention is based on the idea of carrying out the Chemical Vapour Deposition at such a high temperature that a continuous sublimation of material from the substrate takes place, and this is combined with an etching of the substrate through said at least one etching gas in the gas mixture and a deposition of elements resulting from decomposition of the precursor gases. This is a totally new way of carrying out epitaxial growth by Chemical Vapour Deposition and involves excellent results. The growth rate may be increased considerably with respect to the conventional Chemical Vapour Deposition technique and the crystalline quality of the material grown may at the same time be maintained or even improved. It has turned out that in the practice regions of low crystalline quality of a substrate are etched away, while regions of high quality, having stronger chemical bonding, are etched at a much slower rate. Thus, regions of high crystalline quality expand at the expense of low quality regions. Accordingly, the interaction of deposition on one hand and etching and sublimation on the other for said growth promotes the formation of a crystal with a high crystalline quality. Furthermore, the growth rate will increase considerably by using such a high temperature as defined by "above a temperature level from which sublimation of the material grown starts to increase considerably". By combining the reaction zone and the sublimation zone into one single room, where the precursors are first decomposed, heated and then deposited on the substrate, there is no need to provide any substantial pressure difference between the inlet and the growth zone. By using the same susceptor (the room) for reaction and the growth zone, there is no need for such pressure difference.

The grow rates may be increased by 2-3 orders of magnitude compared to the conventional CVD technique, so that high quality layers may be produced at rates being commercially interesting. Furthermore, the etching by hydrogen or other etching gases of the object grown on said substrate is increased considerably at these higher temperatures, and it has been found that polycrystalline regions, i.e. regions with a lower quality, are more rapidly etched than monocrystalline regions, i.e. regions with a high quality, which results in a higher quality of the crystal grown. Furthermore, it has been found that the concentration of unwanted charge carriers will be dramatically reduced when the grow rate is increased, this effect being rather exponential than proportional, which will make it possible to obtain prolonged minority carrier lifetimes, so that it will be possible to reduce the introduction of unwanted compensating acceptors into SiC layers grown and thereby high-power bipolar devices with a sufficiently long minority carrier lifetime may be produced.

It has also surprisingly been found that the grow rates obtained by the temperature increase according to the invention are high enough for making it very interesting to grow boules by the CVD technique. Thus, it is possible to grow boules while using a gas mixture normally used in the CVD technique, which means a purity of the components used for said growth of several orders of magnitude higher than the source material used for seeded sublimation growth. Furthermore, it will be possible to control the growth process by varying the fluxes of the precursor gases independently, which makes it possible to hold the C/Si-ratio constant during the growth. Additionally, the degree of supersaturation which influences both the grow rate and the formation of micropipes can be varied, without any thermal gradient. Thus, boules having a superior crystalline quality to that obtained by using the seeded sublimation technique may be obtained at commercially interesting grow rates through the High Temperature Chemical Vapour Deposition (HTCVD) according to the invention.

EP-A-0 554 047 describes a device and a method in which the growth of the single crystal on the seed crystal is obtained by using the seeded sublimation technique in the sublimation zone. Accordingly, solid-phase SiC particles formed in a reaction zone 20 are introduced into the sublimation zone and sublimated and transported to the growth zone through a thermal gradient and deposited on the seed crystal. This is, accordingly, a method being totally different from the method according to the present invention, since there is no combination of sublimation from the substrate, etching of the substrate and deposition of elements for the growth on the substrate as taught by the present invention.

According to a preferred embodiment of the invention said circumferential walls of the device form a substantially cylindrical susceptor. It has turned out that this shape of the susceptor will be particularly advantageous for easily obtaining a uniform temperature over the entire susceptor wall while avoiding hot spots.

According to still another preferred embodiment of the invention the inner walls of the susceptor are made of or covered by a plate made of SiC, an alloy of SiC and the material grown or the material grown. Such a plate will contribute to prevent impurities from the walls of the susceptor from being set free and being incorporated in the object grown.

### BRIEF DESCRIPTION OF THE DRAWINGS

With reference to the appended drawings, below follows a specific description of a preferred embodiment of the invention cited as an example.

In the drawings:
Fig 1 is a longitudinal cross-section view of a device according to a first embodiment of the invention,
Fig 2 is a perspective view of the susceptor used in the device of Fig 1 according to a preferred embodiment adapted for epitaxially growing layers, parts of the susceptor wall being broken away so as to illustrate the interior of the susceptor, and
Fig 3 is a view similar to Fig 2 of a susceptor adapted for growing boules by Chemical Vapour Deposition.

### DETAILED DESCRIPTION OF PREFERRED EMBODIMENTS OF THE INVENTION

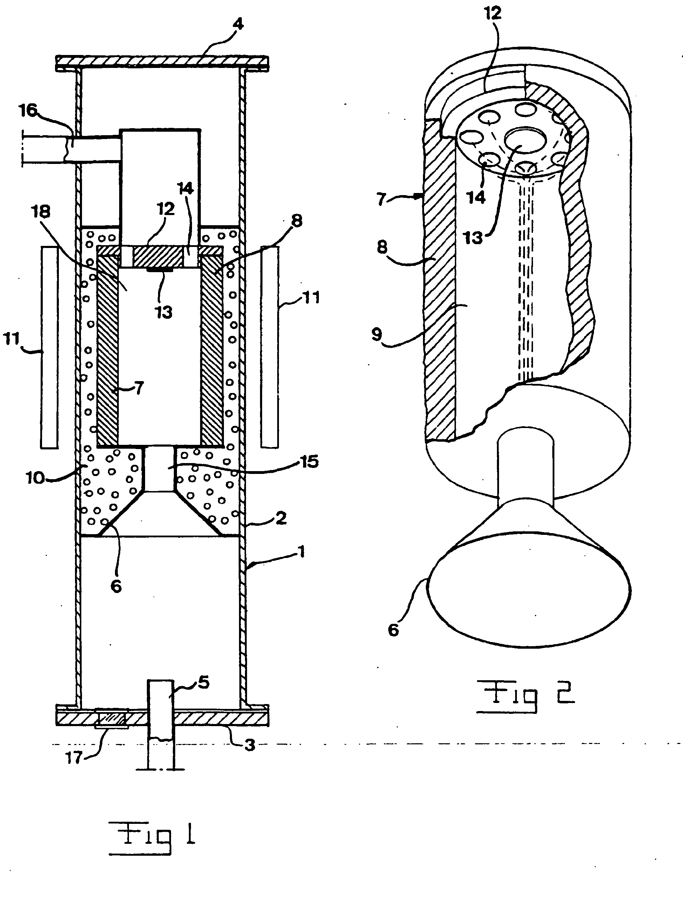

Fig 1 shows schematically a device according to a preferred embodiment of the invention for epitaxially growing SiC by Chemical Vapour Deposition on a SiC-substrate in a simplified manner, and it is obvious that the device in question also comprises other means, such as pumps, but conventional equipment having nothing to do with the invention has been omitted for the sake of clearness and concentration to the inventional characteristics. The device comprises a vacuum casing 1 constituted by a tube 2 of quartz extending substantially vertically and two opposite end flanges 3 and 4. The end flange 4 is preferably removable so as to get access to the interior of the tube 2. A conduit 5 for supplying a stream of a gas mixture intended for the growth of a crystal is introduced through the lower end flange 3. The conduit 5 is connected to separate conduits leading to sources for the respective components of said gas mixture and these conduits are provided with flow regulating means not shown for regulating the content of each component in said gas mixture as desired.

Furthermore, the device comprises a funnel 6 for concentrating the gas flow from the conduit 5 into a susceptor 7 (see also Fig 2). The susceptor 7 shown in Figs 1 and 2 is adapted for epitaxially growing layers of SiC. The susceptor is substantially cylindrical with circumferential walls 8 of a substantially uniform thickness. The walls are made of graphite, but they are internally coated by a layer of SiC 9 or alternatively covered by a cylindrical plate made of SiC. The space surrounding the susceptor is enclosed and filled by graphite foam 10 for thermal insulation for protecting the surrounding quartz tube 2. Rf-field radiating means 11 in the form of a Rf-coil surrounds the tube 2 along the longitudinal extension of the susceptor 7. This heating means 11 is arranged to radiate a Rf-field uniformly heating the walls 8 of the susceptor and thereby the gas mixture introduced into the susceptor.

The susceptor 7 comprises a lid 12 of the same material as the rest of the susceptor, on the lower side of which a SiC substrate 13 is arranged and which may be removed from the rest of the susceptor so as to remove the substrate after a layer has been grown thereon. The lid 12 is provided with peripheral gas outlet holes 14, so that a preferable laminar gas flow will enter the susceptor room 18 through the lower inlet 15 and flow close to the substrate and leave the susceptor through the upper outlets 14 and then the device through a conduit 16 connected to a pump not shown.

The temperature inside the susceptor 7 may be checked pyrometrically through looking into the susceptor 7 through a window indicated at 17.

The function of the device is as follows: a gas mixture including Si- and C-containing precursor gases and one or more carrier gases is led through the conduit 5 in the direction of the susceptor inlet 15. The Si- containing precursor gas is preferably silane, while the C-containing precursor gas is propane or eventually methane. The carrier gas may be H₂, but there may also be a content of a non-etching carrier gas, such as Ar, for a purpose which will be explained below. The heating means 11 will heat the susceptor walls uniformly to a temperature of about 2200°C, which is possible thanks to the substantially uniform thickness thereof resulting in no so called hot spots of the susceptor walls. The precursor gases entering the susceptor 7 will be heated through the susceptor and cracked into Si- and C-atoms, which will be transported to the substrate 13 and deposited thereon for epitaxially growing layers of SiC thereon. Thanks to the vertical arrangement of the susceptor walls the flow upwards of the hot gases heated will be promoted, so that the gases will be better utilized for the growth. The high temperature will lead to a continuous sublimation of SiC from the substrate as well as a considerable etching of the substrate through the etching carrier gas component (H₂), but the supply rate of the precursor gases and the carrier gas or gases is regulated so that a positive growth takes place, i.e. the deposition rate of elements forming the SiC layers grown on the substrate is higher than the rate of material leaving the layers on the substrate due to sublimation and etching. This interaction of deposition on one hand and etching and sublimation on the other for said growth promotes the formation of a crystal with a high crystalline quality, especially since the etching of polycrystalline regions is faster than that of monocrystalline regions. However, an increase of the content of a non-etching carrier gas with a reduction of the content of an etching carrier gas in the gas mixture while raising the temperature will give rise to an etching being below a critical level even at the high temperatures used. This means that the walls of the susceptor may be spared in spite of the high temperatures prevailing. Ar may be used as non-etching carrier gas and H₂ as etching carrier gas.

The initial stage of the growth is particularly important for the quality of the layers grown also thereafter. The grow rate may therefore be kept low at the initial stage of growth to form a smooth uniform layer after which the grow rate gradually can be increased to 100 µm - several millimetres/hour depending on the temperature. Thus, SiC layers may in this way be grown at a high grow rate, possibly from 100 µm to a few millimetres per hour, on the substrate 13, and this high grow rate with said continuous sublimation and etching will give rise to a high quality of the layer grown in spite of the high temperatures, and due to the higher crystalline quality obtained at these temperature and due to a faster healing of crystalline imperfections propagating from the substrate the introduction of unwanted compensating acceptors into the layers grown is dramatically reduced with respect to the epitaxial growth of such layers by CVD at normal temperatures resulting in a significant prolongation of the minority carrier lifetime in the crystals grown. This is a vital improvement for the production of high-power bipolar devices.

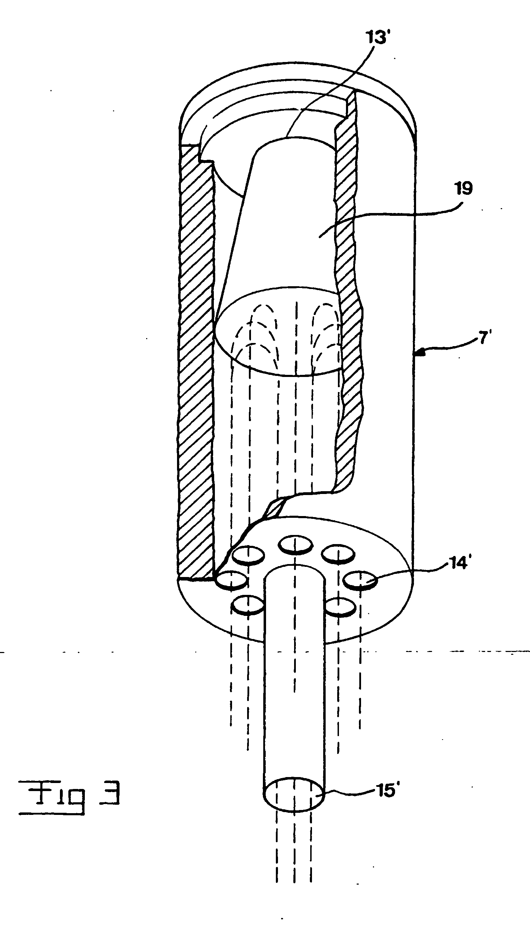

Fig 3 shows a further susceptor 7', which is adapted for growing boules 19 of SiC on a substrate in the form of a seed crystal indicated at 13'. This susceptor is intended to be incorporated in a device according to Fig 1 in the same way as the susceptor according to Fig 2. The susceptor according to Fig 3 only differs from that according to Fig 2 by the arrangement of gas outlet holes 14' at the bottom of the susceptor. Accordingly, the gas streams will as indicated reach the region of the SiC boules grown where the cracked precursor gas components will be deposited and the resulting components thereof will be diverted back and leave the susceptor through the holes 14'.

SiC boules with a high crystalline quality may in this way be epitaxially grown by CVD at a sufficiently high grow rate thanks to the high temperature used. The grow rate may advantageously be higher than 1 millimeter per hour. The C/Si ratio in the susceptor may be held constant thanks to the possibility to vary the content of the precursor gases in the gas mixture. This means that the degree of supersaturation which influences both the grow rate and the formation of micropipes can be varied without any thermal gradient. Additionally, the purity of the gases used are several orders of magnitude higher than the source material used for seeded sublimation growth, so that the crystalline quality of the boules will be much higher than before. The control of the etching is carried out in the way described above for the growth of layers.

The invention is of course not in any way restricted to the preferred embodiment of the device and method described above, but several possibilities to modifications thereof would be apparent for a man skilled in the art without departing from the basic idea of the invention.

The definition "object" in the claims is made for including the epitaxial growth of all types of crystals, such as layers of different thicknesses as well as thick boules.

All definitions concerning the material of course also include inevitable impurities as well as intentional doping.

The claim definition "varying the content" is intended to also comprise a constant supply of the gas in question with a variation of other components of the gas mixture indirectly leading to a variation of the proportion of said gas in the gas mixture.

## Claims

1. A device for epitaxially growing layers of SiC by Chemical Vapour Deposition on a substrate (13) comprising a susceptor (7) having circumferential walls (8) with a substantially uniform thickness surrounding a room (18) for receiving the substrate and means (11) for heating said circumferential susceptor walls and by that the substrate and a gas mixture decomposed by this heating and fed to the substrate for the growth by feeding means, said heating means being arranged to heat the susceptor (7) and by that the substrate (13) above a temperature level from which sublimation of the material grown starts to increase considerably, thus combining both decomposition of gases of the gas mixture and sublimation in the same room (18), said feeding means being arranged to feed a gas mixture including precursor gases to be decomposed into elements for deposition on said substrate for exptaxial growth thereon and at least one etching gas with such a composition and at such a rate into the susceptor that a positive growth takes place, i.e. the deposition rate of elements forming the material grown on the substrate is higher than the rate of material leaving the layers on the substrate due to sublimation and etching, said circumferential walls extending substantially vertically in the direction of the gas feed into the susceptor, said susceptor having a lower inlet (15) for said gas mixture and an upper gas outlet (14) for a gas flow in the susceptor from the lower inlet to the substrate (13) and then out through the upper outlet (14).

2. A device according to claim 1, **characterized in that** said circumferential walls (8) form a substantially cylindrical susceptor (7).

3. A device according to claim 1 or 2, **characterized in that** the inner walls of the susceptor are made of or covered by a plate made of SiC, an alloy of SiC and the material grown or the material grown.

4. A device according to any of claims 1-3, **characterized in that** it is adapted for growing layers of SiC, and that said heating means (11) is arranged to heat the susceptor walls (8) to a temperature above 1900 degrees C.

5. A device according to claim 4, **characterized in that** said heating means (11) is arranged to heat the susceptor walls (8) to a temperature between 2000 and 2500 degrees C.

6. A device according to any of claims 1-5, **characterized in that** said heating means (11) is a Rf-field radiating means surrounding said circumferential susceptor walls (8).

7. A method for epitaxially growing objects of SiC by Chemical Vapour Deposition on a substrate (13, 13') arranged to be received by a susceptor (7, 7') having circumferential walls with a substantially uniform thickness surrounding a room, said substrate and a gas mixture fed to the substrate for said growth being heated through heating of the susceptor walls, **characterized in that** the etching action of said gas mixture upon the susceptor and substrate is varied by varying the content of at least one etching gas in said gas mixture, that the substrate is heated by heating the susceptor (7, 7') above a temperature level from which sublimation of the material grown starts to increase considerably, and that the content of said at least one etching gas in the gas mixture and the supply rate of precursor gases to be decomposed into elements for deposition on the substrate for exptaxial growth thereon included in the gas mixture are regulated so that a positive growth takes place, i.e. the deposition rate of elements forming the material grown on the substrate is higher than the rate of material leaving the layers on the substrate due to sublimation and etching.

8. A method according to claim 7, **characterized in that** said etching action is varied by varying the content of a carrier gas of said gas mixture.

9. A method according to claim 8, **characterized in that** said content is varied by increasing the content of a non-etching carrier gas with a reduction of the content of said etching carrier gas in said gas mixture and vice versa.

10. A method according to claim 9, **characterized in that** the content of said non-etching carrier gas is increased upon an increase of the temperature of the susceptor and by that of the gas mixture.

11. A method according to claim 9 or 10, **characterized in that** said non-etching gas is Ar.

12. A method according to any of claims 7-11, **characterized in that** said etching gas is H₂.

13. A method according to claim 7, **characterized in that** SiC is grown and that the substrate is heated at a temperature above 1900 degrees C.

14. A method according to claim 13, **characterized in that** the substrate is heated at a temperature between 2000 and 2500 degrees C.

15. A method according to any of claims 9-14, **characterized in that** boules (19) are grown on a substrate (13') in the form of a seed crystal.

16. A method according to claim 15, **characterized in that** said heating is carried out at a temperature within the temperature range used when such boules are produced by a conventional seeded sublimation technique.

17. A method according to any of claims 7-14, **characterized in that** layers are grown on the substrate (13).

## Patentansprüche

1. Vorrichtung zum epitaktischen Wachsen von Schichten aus SiC durch chemische Gasphasenabscheidung auf einem Substrat (13), umfassend einen Suszeptor (7) mit Umfangswänden (8) mit einer im wesentlichen gleichförmiger Dicke, die einen Raum (18) zum Aufnehmen des Substrats umgeben, und ein Mittel (11) zum Erwärmen des Suszeptorumfangswände und **dadurch** des Substrats und einer Gasmischung, die durch dieses Erwärmen zersetzt und dem Substrat durch ein Zuführmittel für das Wachstum zugeführt wird, wobei das Heizmittel ausgebildet ist, um den Suszeptor (7) und **dadurch** das Substrat (13) oberhalb eines Temperaturniveau erwärmen, ab dem die Sublimation des gewachsenen Materials deutlich anzusteigen beginnt, so dass die Zersetzung des Gases der Gasmischung und die Sublimation beide in dem selben Raum (18) kombiniert werden, wobei das Zuführmittel ausgebildet ist, um eine Gasmischung, einschließlich Precursorgase zum Zersetzen in Elemente für die Abscheidung auf dem Substrat für ein epitaktisches Wachstum darauf, und mindestens ein Ätzgas mit einer derartigen Zusammensetzung und mit einer derartigen Rate in den Suszeptor einzuführen, dass ein positives Wachstum stattfindet, d.h. die Abscheiderate der Elemente, die das gewachsene Material auf dem Substrat bilden, größer ist als die Rate des Materials, das die Schichten auf dem Substrat aufgrund von Sublimation und Ätzen verlässt, wobei sich die Umfängswände im wesentlichen vertikal in Richtung der Gaszuführung in dem Suszeptor erstrecken, wobei der Suszeptor einen unteren Einlass (15) für die Gasmischung und einen oberen Gasauslass (14) für eine Gasströmung in dem Suszeptor von dem unteren Einlass zu dem Substrat (13) und dann durch den oberen Auslass (14) hinaus aufweist.

2. Vorrichtung nach Anspruch 1, **dadurch gekennzeichnet, dass** die Umfangswände (8) einen im wesentlichen zylindrischen Suszeptor (7) bilden.

3. Vorrichtung nach Anspruch 1 oder 2, **dadurch gekennzeichnet, dass** die inneren Wände des Suszeptors aus SiC, aus einer Legierung von SiC und dem gewachsenen Material oder aus dem gewachsenen Material hergestellt sind oder mit einer Platte bedeckt sind, die aus SiC, aus einer Legierung von SiC und dem gewachsenen Material oder aus dem gewachsenen Material hergestellt ist.

4. Vorrichtung nach einem der Ansprüche 1 bis 3 **dadurch gekennzeichnet, dass** sie für das Wachsen von Schichten aus SiC angepasst ist und dass das Heizmittel (11) zum Erwärmen der Suszeptorwände (8) auf eine Temperatur oberhalb 1900°C ausgebildet ist.

5. Einrichtung nach Anspruch 4, **dadurch gekennzeichnet, dass** das Heizmittel (11) zum Erwärmen der Suszeptorwände (8) auf eine Temperatur zwischen 2000°C und 2500°C ausgebildet ist.

6. Vorrichtung nach einem der Ansprüche 1 bis 5, **dadurch gekennzeichnet, dass** das Heizmittel (11) ein HF-Feld abstrahlendes Mittel ist, das die Suszeptorumfangswände (8) umgibt.

7. Verfahren zum epitaktischen Wachsen von Gegenständen aus SiC durch chemische Gasphasenabscheidung auf einem Substrat (13, 13'), das ausgebildet ist, um von einem Suszeptor (7, 7') mit Umfangswänden mit im wesentlichen gleichförmiger Dicke, die einen Raum umgeben, aufgenommen zu werden, wobei das Substrat und eine dem Substrat für das Wachstum zugeführte Gasmischung durch Erwärmen der Suszeptorwände erwärmt werden, **dadurch gekennzeichnet, dass** die Ätzwirkung der Gasmischung am Suszeptor und am Substrat durch das Variieren des Inhalts von mindestens einem Ätzgas in der Gasmischung variiert wird, dass das Substrat durch Erwärmen des Suszeptors (7, 7') oberhalb eines Temperaturniveaus erwärmt wird, ab dem die Sublimation des gewachsenen Materials deutlich anzuwachsen beginnt, und dass der Inhalt des mindestens einen Ätzgases in der Gasmischung und die Zufuhrrate von Precursorgasen, die für die Abscheidung auf dem Substrat für das epitaktische Wachstum darauf in Elemente zu zerlegen sind und die in der Gasmischung enthalten sind, derart geregelt werden, dass ein positives Wachstum stattfindet, d.h. die Abscheiderate der Elemente, die das gewachsene Material auf dem Substrat bilden, größer ist als die Rate des Materials, das die Schichten auf dem Substrat aufgrund von Sublimation und Ätzen verlässt.

8. Verfahren nach Anspruch 7, **dadurch gekennzeichnet, dass** die Ätzwirkung durch das Variieren des Inhalts eines Trägergases der Gasmischung variiert wird.

9. Verfahren nach Anspruch 8, **dadurch gekennzeichnet, dass** der Inhalt variiert wird, indem der Inhalt eines nichtätzenden Trägergases mit einer Verminderung des Inhalts des ätzenden Trägergases in der Gasmischung erhöht wird und umgekehrt.

10. Verfahren nach Anspruch 9, **dadurch gekennzeichnet, dass** der Inhalt des nichtätzenden Trägergases bei einem Anstieg der Temperatur des Suszeptors und **dadurch** der Gasmischung erhöht wird.

11. Verfahren nach Anspruch 9 oder 10, **dadurch gekennzeichnet, dass** das nichtätzende Gas Ar ist.

12. Verfahren nach einem der Ansprüche 7 bis 11, **dadurch gekennzeichnet, dass** das ätzende Gas H₂ ist.

13. Verfahren nach Anspruch 7, **dadurch gekennzeichnet, dass** SiC gewachsen wird und dass das Substrat auf eine Temperatur oberhalb 1900°C aufgeheizt wird.

14. Verfahren nach Anspruch 13, **dadurch gekennzeichnet, dass** das Substrat auf eine Temperatur zwischen 2000°C und 2500°C aufgeheizt wird.

15. Verfahren nach einem der Ansprüche 7 bis 12, **dadurch gekennzeichnet, dass** Einkristallkörper (19) auf einem Substrat (13`) in der Gestalt eines Keimkristalls gewachsen werden.

16. Verfahren nach Anspruch 15, **dadurch gekennzeichnet, dass** das Aufheizen auf eine Temperatur innerhalb des Temperaturbereichs durchgeführt wird, der verwendet wird, wenn derartige Einkristallkörper durch eine herkömmliche Keimsublirnationstechnik erzeugt werden.

17. Verfahren nach einem der Ansprüche 7 bis 14, **dadurch gekennzeichnet, dass** auf dem Substrat (13) Schichten gewachsen werden.

## Revendications

1. Dispositif de croissance épitaxiale de couches en SiC, par dépôt chimique en phase vapeur sur un substrat (13) comprenant un suscepteur (7) ayant des parois (8) circonférentielles d'une épaisseur sensiblement uniforme entourant une chambre (18) de réception du substrat et des moyens (11) de chauffage des parois circonférentielles du suscepteur, et en ce que le substrat et un mélange gazeux est décomposé par ce chauffage et envoyé au substrat pour la croissance par des moyens d'alimentation, les moyens de chauffage étant agencés de manière à chauffer le suscepteur (7) et en ce que le substrat (13) est au-dessus d'un niveau de température à partir duquel une sublimation du matériau en croissance commence à augmenter considérablement, en combinant ainsi à la fois une décomposition des gaz du mélange gazeux et une sublimation dans la même chambre (18), les moyens d'alimentation étant agencés pour envoyer un mélange gazeux comprenant des gaz précurseurs à décomposer en des éléments pour un dépôt sur le substrat pour une croissance épitaxiale sur celui-ci et au moins un gaz d'attaque ayant une composition telle et à un débit tel dans le suscepteur qu'une croissance positive a lieu, c'est-à-dire que la vitesse de dépôt des éléments formant le matériau en croissance sur le substrat est plus grande que la vitesse de matériau quittant les couches sur le substrat due à la sublimation et à l'attaque, les parois circonférentielles s'étendant sensiblement verticalement dans la direction de l'alimentation de gaz dans le suscepteur, ce suscepteur ayant une entrée (15) inférieure pour le mélange gazeux et une sortie (14) supérieure pour un courant de gaz dans le suscepteur allant de l'entrée inférieure au substrat (13) puis sortant par la sortie (14) supérieure.

2. Dispositif suivant la revendication 1, **caractérisé en ce que** les parois (8) circonférentielles forment un suscepteur (7) sensiblement cylindrique.

3. Dispositif suivant la revendication 1 ou 2, **caractérisé en ce que** les parois intérieures du suscepteur sont en SiC, en un alliage de SiC et du matériau en croissance ou en le matériau en croissance ou sont revêtues d'une plaque en SiC, en un alliage de SiC et du matériau en croissance ou en le matériau en croissance.

4. Dispositif suivant l'une quelconque des revendications 1 à 3, **caractérisé en ce qu'**il est adapté pour faire croître des couches en SiC et **en ce que** les moyens (11) de chauffage sont agencés pour chauffer les parois (8) du suscepteur à une température supérieure à 1 900 °C.

5. Dispositif suivant la revendication 4, **caractérisé en ce que** les moyens (11) de chauffage sont agencés pour chauffer les parois (8) du suscepteur à une température comprise entre 2 000 et 2 500 °C.

6. Dispositif suivant l'une quelconque des revendications 1 à 5, **caractérisé en ce que** les moyens (11) de chauffage sont des moyens de rayonnement à champ radiofréquence entourant les parois (8) circonférentielles du suscepteur.

7. Procédé de croissance épitaxiale d'objets en SiC, par dépôt chimique en phase vapeur sur un substrat (13, 13') destiné à être reçu par un suscepteur (7, 7') comportant des parois circonférentielles d'une épaisseur sensiblement uniforme entourant une pièce, le substrat et un mélange gazeux envoyé pour la croissance étant chauffés en chauffant les parois du suscepteur, **caractérisé en ce que** l'action d'attaque chimique du mélange gazeux sur le suscepteur et le substrat est modifiée en modifiant la teneur en au moins un gaz d'attaque du mélange gazeux, **en ce que** le substrat est chauffé en chauffant le suscepteur (7, 7') au-dessus d'un niveau de température à partir duquel une sublimation du matériau en croissance commence à augmenter considérablement et **en ce que** la teneur du au moins un gaz d'attaque chimique du mélange gazeux et le débit d'alimentation des gaz précurseurs à décomposer en des éléments pour un dépôt sur le substrat pour y effectuer une croissance épitaxiale et inclus dans le mélange gazeux sont réglés de façon à ce qu'une croissance positive ait lieu, c'est-à-dire que la vitesse de dépôt des éléments formant le matériau en croissance sur le substrat est supérieure à la vitesse du matériau quittant les couches sur le substrat en raison d'une sublimation et d'une attaque chimique.

8. Procédé suivant la revendication 7, **caractérisé en ce que** l'action d'attaque chimique est modifiée en modifiant la teneur d'un gaz support du mélange gazeux.

9. Procédé suivant la revendication 8, **caractérisé en ce que** la teneur est modifiée en augmentant la teneur d'un gaz porteur dépourvu d'effet d'attaque chimique avec une réduction de la teneur en le gaz porteur d'attaque chimique du mélange gazeux et vice versa.

10. Procédé suivant la revendication 9, **caractérisé en ce que** la teneur en le gaz porteur qui n'a pas d'effet d'attaque est augmentée après élévation de la température du suscepteur et de celle du mélange gazeux.

11. Procédé suivant la revendication 9 ou 10, **caractérisé en ce que** le gaz qui n'a pas d'effet d'attaque est Ar.

12. Procédé suivant l'une quelconque des revendications 7 à 11, **caractérisé en ce que** le gaz d'attaque est H₂.

13. Procédé suivant la revendication 7, **caractérisé en ce que** l'on fait croître du SiC et **en ce que** l'on porte le substrat à une température supérieure à 1 900 °C.

14. Procédé suivant la revendication 13, **caractérisé en ce que** l'on porte le substrat à une température comprise entre 2 000 et 2 500 °C.

15. Procédé suivant l'une quelconque des revendications 9 à 14, **caractérisé en ce que** l'on fait croître des boules (19) sur un substrat (13') sous la forme d'un cristal germe.

16. Procédé suivant la revendication 15, **caractérisé en ce que** l'on effectue le chauffage à une température comprise dans la plage de températures utilisées quand on produit ces boules par une technique classique de sublimation à des germes.

17. Procédé suivant l'une quelconque des revendications 7 à 14, **caractérisé en ce que** l'on fait croître des couches sur le substrat (13).
